# FASCICULE DE BREVET EUROPEEN

(11) **EP 3 435 436 B1**
(45) Date de publication et mention de la délivrance du brevet: **13.04.2022**
(21) Numéro de dépôt: 18185352.4
(22) Date de dépôt: 24.07.2018
(51) Int. Cl.: H01L 51/46

(54) **EMPILEMENT MULTICOUCHE UTILE À TITRE DE COUCHE P POUR DISPOSITIF PHOTOVOLTAIQUE**
MEHRSCHICHTENSTAPELUNG, DIE ALS P-SCHICHT FÜR EINE FOTOVOLTAIKVORRICHTUNG NÜTZLICH IST
MULTILAYER STACK USEFUL AS P LAYER FOR PHOTOVOLTAIC DEVICE

(30) Priorité: 25.07.2017 FR 1757035
(43) Date de publication de la demande: 30.01.2019
(73) Titulaire: Commissariat à l'Energie Atomique et aux Energies Alternatives, 75015 Paris (FR)
(72) Inventeur: MANCEAU, Matthieu, 38054 GRENOBLE CEDEX 09 (FR)
(74) Mandataire: Nony

(56) Documents cités:
- WO-A1-2016/014845
- WO-A1-2016/187265
- WO-A2-2015/187225
- JP-A- 2015 231 048
- US-A1- 2016 254 472

## Description

La présente invention concerne le domaine des dispositifs photovoltaïques, en particulier des cellules photovoltaïques de type pérovskite.

Les dispositifs photovoltaïques, et en particulier les cellules photovoltaïques, comprennent généralement un empilement multicouche, comportant une couche photoactive, dite couche « active ».

Dans les cellules photovoltaïques dites pérovskites, cette couche active est couramment constituée d'un matériau de type pérovskite hybride organique-inorganique. La couche active des cellules photovoltaïques est au contact de part et d'autre avec une couche de type N et une couche de type P. Ce type d'ensemble multicouche, constitué de la superposition de la couche active et des deux couches de type P et de type N décrites ci-dessus est classiquement dénommé NIP ou PIN suivant l'ordre d'empilement des différentes couches sur le substrat.

La couche de type N est généralement constituée d'un oxyde semi-conducteur de type N, par exemple ZnO, AZO (oxyde de zinc dopé à l'aluminium), SnO₂ ou TiOₓ (x < 2).

Dans ce type de matériaux de type pérovskite, la couche P des dispositifs photovoltaïques est, dans l'immense majorité des cas, constituée d'un matériau organique semi-conducteur qui peut être soit un polymère π-conjugué, à l'image par exemple du poly-(3-hexylthiophène) ou P3HT, ou plus fréquemment une petite molécule comme le Spiro-MeOTAD. (J. WEBER et al., Solar Energy Materials & Solar cells 141 (2015) 407-413) ou encore tels que ceux proposés dans le document WO 2016/187265.

Les documents WO 2015/187225 A2 et WO 2016/014845 A1 divulguent un empilement multicouche utile pour former un dispositif photovoltaïque ayant la configuration suivante : ITO/TiO₂(ou TiO₂/PC₆₁BM)/perovskite/MoO₃/P3HT/Ag.

Pour sa part, le document US 2016/254472 décrit une structure de type PIN pour une cellule photovoltaïque pérovskite dont la couche P contient du PEDOT:PSS et un polymère semi-conducteur, le TFB, qui a une fonction de promoteur de la cristillanité de la couche pérovskite dédiée à lui être superposée.

Si ces matériaux permettent d'atteindre des performances relativement élevées, ils présentent néanmoins certaines insuffisances, notamment en termes de conductivité, ce qui limite fortement les possibilités d'utilisation de grille métallique en guise d'électrode supérieure, et de transparence, ce qui est un handicap certain dans l'optique de la réalisation de cellules tandem devant être éclairées par la couche semi-conductrice de type P.

Ainsi, les inventeurs ont constaté que, lorsque le P3HT est utilisé seul en tant que couche de type P, l'épaisseur nécessaire à l'obtention de bonnes performances PV est typiquement de l'ordre de 80 nm. Compte-tenu des propriétés optiques de ce matériau, ceci se traduit par une absorption relativement forte et, par conséquent, une transmission très limitée (typiquement de l'ordre de 10 % au pic d'absorption). De façon évidente, une réduction de l'épaisseur utilisée entraîne une diminution de l'absorption de la couche. Malheureusement, des épaisseurs faibles permettant d'atteindre une haute transparence (> 70%) ne permettent pas d'atteindre des rendements PV élevés en dispositifs car une si faible épaisseur ne permet pas une sélection efficace des porteurs de charges à cette interface.

La présente invention vise précisément à proposer un nouveau type d'empilement permettant d'améliorer efficacement le compromis transparence/conductivité.

La présente invention vise notamment à proposer un empilement multicouche utile pour former un dispositif, en particulier une cellule, photovoltaïque, ledit empilement comportant au moins une succession de couches superposées et jointives les unes aux autres dans l'ordre suivant :
(a) une couche semi-conductrice de type N, dite « couche d'injection d'électrons » (en langue anglaise « Electron Injection Layer » ou EIL) ;
(b) une couche active de type pérovskite ; et
(c) une structure conductrice de type P, dite « couche de transport de trous » (en langue anglaise « Hole transport layer » ou HTL) comprenant au moins une couche d'un matériau conducteur à base de poly(3,4-éthylènedioxythiophène) (PEDOT) associé à un ou plusieurs contre-ions choisis parmi le poly(styrène sulfonate) (PSS), le tosylate (OTs), le triflate (OTf) et le méthylsulfonate (OMs) ;
caractérisé en ce que la structure de type P comprend en outre au moins une couche de polymère semi-conducteur π-conjugué, distinct du PEDOT, qui est jointive à l'une des faces de ladite couche de matériau conducteur à base de PEDOT.

Ainsi, l'invention concerne un empilement multicouche utile pour former un dispositif photovoltaïque, ledit empilement comportant au moins une succession de couches superposées et jointives les unes aux autres dans l'ordre suivant :
(a) une couche semi-conductrice de type N, dite couche d'injection d'électrons ;
(b) une couche active de type pérovskite ;
(c) une structure conductrice de type P, dite couche de transport de trous, comprenant au moins une couche d'un matériau conducteur à base de poly(3,4-éthylènedioxythiophène) (PEDOT) associé à un ou plusieurs contre-ions choisis parmi le poly(styrène sulfonate) (PSS), le tosylate (OTs), le triflate (OTf) et le méthylsulfonate (OMs) ;
caractérisé en ce que la structure de type P comprend en outre au moins une couche de polymère semi-conducteur π-conjugué, distinct du PEDOT et comprenant au moins un motif thiophène, ladite couche étant jointive à l'une des faces de ladite couche de matériau conducteur à base de PEDOT,
ladite couche de matériau conducteur à base de PEDOT avec contre-ion(s) possédant une épaisseur inférieure ou égale à 200 nm, et
ladite couche en polymère semi-conducteur π-conjugué possédant une épaisseur inférieure ou égale à 20 nm.

Selon un mode de réalisation particulièrement préféré, la structure conductrice de type P comprend au moins une couche de PEDOT:PSS.

Selon un mode de réalisation particulier, le polymère semi-conducteur π-conjugué considéré selon l'invention est le poly(3-hexylthiophène) ou P3HT.

Le PEDOT:PSS est connu comme possédant une transmission élevée, typiquement supérieure à 80% dans la gamme d'intérêt des cellules pérovskites. En revanche, il ne permet pas d'atteindre des performances comparables à celles des cellules à base de P3HT « standards » (80 nm).

L'utilisation de PEDOT:PSS comme matériau de type P a jusqu'à présent été privilégiée dans des dispositifs photovoltaïques organiques, le PEDOT :PSS étant formulé en milieu aqueux. De telles formulations aqueuses ne sont en revanche pas adaptées pour être mises en contact directement avec une couche active constituée d'un matériau de type pérovskite hybride organique-inorganique.

De manière inattendue, les inventeurs ont constaté, d'une part, qu'il est néanmoins possible de considérer la mise en œuvre d'un tel matériau PEDOT dans des cellules photovoltaïques de type pérovskite à partir de formulations apolaires de PEDOT, sous réserve de lui associer jointivement une couche de polymère semi-conducteur π-conjugué et, d'autre part, qu'une telle association s'avère particulièrement avantageuse en termes de conductivité et de transparence.

Un empilement selon l'invention est donc tout particulièrement utile pour l'élaboration de dispositifs photovoltaïques, en particulier de cellules photovoltaïques de type pérovskite, voire de cellules photovoltaïques de type pérovskite en tandem.

Ainsi, selon un autre de ses aspects, la présente invention concerne un dispositif photovoltaïque, en particulier une cellule photovoltaïque de type pérovskite, notamment de type tandem, comportant au moins un empilement comportant au moins une succession de couches superposées et jointives les unes aux autres dans l'ordre suivant :
- une couche transparente conductrice en tant que première électrode et formant l'anode, par exemple en oxyde d'étain dopé à l'indium (ITO) ;
- une couche semi-conductrice de type N, dite « couche d'injection d'électrons » (en langue anglaise « Electron Injection Layer » ou EIL) ;
- une couche active de type pérovskite ;
- une structure conductrice de type P, dite « couche de transport de trous » (en langue anglaise « Hole transport layer » ou HTL) comprenant au moins une couche d'un matériau conducteur à base de PEDOT associé à un ou plusieurs contre-ions choisis parmi le poly(styrène sulfonate) (PSS), le tosylate (OTs), le triflate (OTf) et le méthylsulfonate (OMs) ; et
- une couche conductrice en tant que seconde électrode et formant la cathode, par exemple en argent ou en or ;
caractérisé en ce que la structure de type P comprend en outre au moins une couche de polymère semi-conducteur π-conjugué, distinct du PEDOT, qui est jointive à l'une des faces de ladite couche de matériau conducteur à base de PEDOT.

Selon une première variante, la structure conductrice de type P (c) est formée d'une couche de matériau conducteur à base de PEDOT avec contre-ion(s) et d'une couche dudit polymère semi-conducteur π-conjugué disposée à l'interface de ladite couche à base de PEDOT avec contre-ion(s) et de ladite couche active (b).

Selon une seconde variante, la structure conductrice de type P (c) est formée d'une couche de matériau conducteur à base de PEDOT avec contre-ion(s) et d'une couche de polymère semi-conducteur π-conjugué disposée sur la face de ladite couche de matériau conducteur à base de PEDOT non contigüe à la couche active (b).

Selon une troisième variante, la structure conductrice de type P est constituée de la succession de couches superposées et jointives les unes aux autres dans l'ordre suivant : couche dudit polymère semi-conducteur π-conjugué / couche de matériau conducteur à base de PEDOT avec contre-ion(s)/ couche dudit polymère semi-conducteur π-conjugué.

Comme il ressort des exemples ci-après, les inventeurs ont constaté qu'une structure conductrice de type P conforme à l'invention permet de réaliser des dispositifs performants, permettant d'accéder à un bon compromis transparence/conductivité.

Elle permet avantageusement de réaliser des dépôts conducteurs semitransparents, notamment avec une transparence supérieure à 70 % voire supérieure à 80 %, et qui ne dégradent pas la pérovskite.

Dans la suite du texte, les expressions « compris entre ... et ... », « allant de ... à ... » et « variant de ... à ... » sont équivalentes et entendent signifier que les bornes sont incluses, sauf mention contraire.

Sauf indication contraire, l'expression « comportant/comprenant un(e) » doit être comprise comme « comportant/comprenant au moins un(e) ».

L'invention pourra être mieux comprise à la lecture de la description détaillée qui va suivre, donnée en référence aux dessins annexés, sur lesquels :
- la figure 1 illustre, de manière schématique, dans un plan vertical de coupe, un empilement classique de cellule photovoltaïque (31) ;
- la figure 2 représente, de manière schématique, dans un plan vertical de coupe, une structure multicouche d'une cellule photovoltaïque (31) selon l'invention.
- la figure 3 représente les spectres de transmittance d'une couche conductrice de type P conforme à l'invention, i.e. formée d'un empilement P3HT (15 nm) / PEDOT:PSS (100 nm) déposée sur un substrat de verre, obtenue selon l'exemple 1.

### STRUCTURE CONDUCTRICE DE TYPE P SELON L'INVENTION

Comme précisé ci-dessus, l'empilement selon l'invention relève de la constatation surprenante par les inventeurs que la réalisation d'une structure en matériau conducteur de type P (c) comprenant au moins une fine couche d'un matériau de type polymère π-conjugué jointive à une couche de matériau conducteur de type PEDOT, avec ladite couche de matériau de type polymère π-conjugué étant disposée à l'interface de ladite couche de matériau conducteur à base de PEDOT et de la couche électriquement active de type pérovskite (b) et/ou à l'interface de ladite couche de matériau conducteur à base de PEDOT et de la couche conductrice en tant que seconde électrode, permet d'accéder à un compromis avantageux entre la conductivité et la transparence.

En ce qui concerne, la couche de polymère semi-conducteur π-conjugué, elle possède une épaisseur inférieure à celle de la couche de matériau conducteur à base de PEDOT à laquelle elle est jointive.

La couche de polymère semi-conducteur π-conjugué possède une épaisseur inférieure ou égale à 20 nm et de préférence inférieure ou égale à 15 nm.

En particulier, la couche de polymère semi-conducteur π-conjugué possède une épaisseur supérieure à 5 nm et de préférence variant de 10 à 15 nm.

La couche de matériau conducteur à base de PEDOT avec contre-ion(s) possède une épaisseur inférieure ou égale à 200 nm et idéalement inférieure ou égale à 100 nm.

En particulier, la couche de matériau conducteur à base de PEDOT avec contre-ion(s) possède une épaisseur supérieure ou égale à 50 nm et de préférence variant de 50 à 100 nm.

Ces épaisseurs peuvent être mesurées avec un profilomètre, par exemple de dénomination commerciale KLA Tencor.

Ainsi, la couche de polymère semi-conducteur π-conjugué (SC) et la couche de matériau conducteur de type PEDOT avec contre-ion(s) (C) peuvent être considérées dans un rapport d'épaisseur (SC)/(C) compris entre 1/100 et 1/5, et de préférence de l'ordre de 1/10, dans une architecture considérant une unique couche de chacun des matériaux.

Dans la variante où la structure conductrice de type P est formée d'un empilement formé d'une couche dudit polymère semi-conducteur π-conjugué (SC)/ couche de matériau conducteur à base de PEDOT avec contre-ion(s) (C)/ couche dudit polymère semi-conducteur π-conjugué annexe (SC), le rapport d'épaisseur (SC)/(C)/(SC) peut être compris entre 1/100/1 et 1/5/1, et de préférence est de l'ordre de 1/10/1.

Les deux types de couches de matériaux considérées pour réaliser la structure conductrice de type P selon l'invention permettent avantageusement d'accéder à une transparence supérieure à 70 %, voire supérieure à 80 %.

La transmittance peut être par exemple mesurée par spectrométrie UV-Vis-IR, par exemple à l'aide d'une sphère d'intégration sur un spectromètre de type Varian Carry 5000.

### Polymère semi-conducteur π-conjugué

Comme indiqué précédemment, la structure conductrice de type P selon l'invention comprend au moins une couche en polymère semi-conducteur π-conjugué.

Au sens de la présente invention, ce polymère π-conjugué est distinct du PEDOT.

Il est en particulier choisi parmi les polymères semi-conducteurs π-conjugués comportant au moins un motif thiophène.

Il est entendu qu'un motif thiophène est un groupe de formule suivante : 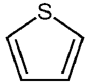 éventuellement substitué sur un ou plusieurs de ses atomes de carbone.

Il peut être notamment choisi parmi les poly(3-hexylthiophène) ou P3HT, poly[N- 9'-heptadecanyl-2,7-carbazole-alt-5,5-(4,7-di-2-thienyl-2',1',3'-benzothiadiazole ou PCDTBT, poly[2,1,3-benzothiadiazole-4,7-diyl[4,4-bis(2-ethylhexyl)-4H-cyclopenta[2,1-b:3,4-b']dithiophene-2,6-diyl]] ou PCPDTBT, le Poly(benzo[1,2-b:4,5-b']dithiophene-alt-thieno[3,4-c]pyrrole-4,6-dione) PBDTTPD, poly[[4,8-bis[(2-ethylhexyl)oxy] benzo [1,2-b:4,5-b']dithiophene-2,6-diyl][3-fluoro-2-[(2-ethylhexyl) carbonyl]thieno[3,4-b]thiophenediyl]] ou PTB7.

Selon un mode de réalisation particulier, le polymère semi-conducteur π-conjugué considéré selon l'invention est un poly(3-hexylthiophène) ou P3HT.

### Matériau conducteur de type PEDOT

Selon une autre caractéristique essentielle de l'invention, la structure conductrice de type P selon l'invention comprend au moins une couche à base d'un matériau de type poly(3,4-éthylènedioxythiophène) (PEDOT).

Le PEDOT est mis en œuvre sous une forme combinée à un contre-ion, plus particulièrement choisi parmi le poly(styrène sulfonate) (PSS), le tosylate (OTs), le triflate (OTf) et le méthylsulfonate (OMs), en particulier le poly(styrène sulfonate) (PSS)

Le ratio PEDOT : contre-ion influence à la fois les propriétés de mise en œuvre et la conductivité du film sec. Selon les performances visées, il peut être compris entre 1:1.5 et 1:20 en masse. Avantageusement il est compris entre 1:2 et 1:30 en masse.

La couche de matériau conducteur peut ainsi être une couche de PEDOT sous une forme combinée avec un ou plusieurs contre-ions tels que décrits précédemment, par exemple de PEDOT:PSS, de PEDOT:OTs ou de PEDOT:OTf.

De préférence, la structure conductrice de type P selon l'invention comprend une couche de PEDOT:PSS.

Les polymères de type PEDOT : PSS comprennent :
- du poly(3,4-EthylèneDiOxyThiophène) ou PEDOT de structure chimique : 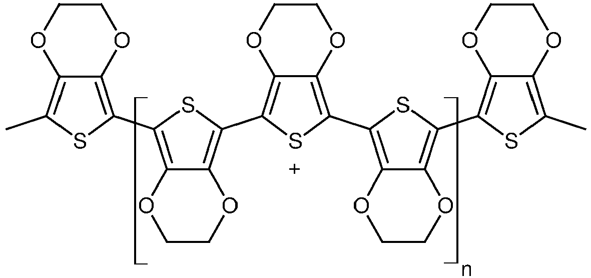 avec n un nombre entier positif ; et
- du PolyStyrèneSulfonate ou PSS sous forme protonée (à droite) ou non (à gauche), de structure chimique : 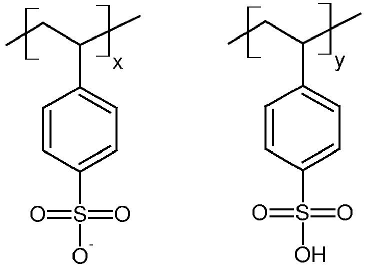 avec x et y des nombres entiers positifs.

Comme détaillé dans la suite du texte, la couche conductrice à base de PEDOT d'une structure conductrice de type P selon l'invention est formée à partir d'une formulation dudit matériau conducteur PEDOT associé à un ou plusieurs contre-ions en milieu apolaire, à la différence des solutions de PEDOT en solvant aqueux généralement mises en œuvre pour des dispositifs PV organiques.

De préférence, la structure conductrice de type P selon l'invention comprend, en particulier est formée de, une couche de PEDOT:PSS et d'une ou de deux couches de P3HT.

Ainsi, selon une variante de réalisation, un empilement selon l'invention comprend, à titre de structure conductrice de type P (c), au moins une couche de P3HT disposée à l'interface de ladite couche active de type pérovskite (b) et d'une couche de PEDOT:PSS et/ou disposée sur la face de ladite couche PEDOT:PSS non contigüe à la couche active (b). En d'autres termes, il s'agit de la face dédiée à être jointive à la seconde électrode.

### COUCHE ACTIVE DE TYPE PEROVSKITE

Un tel matériau pérovskite est plus particulièrement de formule générale ABX₃, avec :
- A représentant un cation ou une combinaison de cations ;
- B représentant un ou plusieurs éléments métalliques, tels que le plomb (Pb), l'étain (Sn), le bismuth (Bi) et l'antimoine (Sb) ; et
- X représentant un ou plusieurs anions, en particulier un ou plusieurs halogènes, et plus particulièrement choisis parmi le chlore, le brome, l'iode et leurs mélanges.

De tels matériaux pérovskites sont par exemple décrits dans le document WO 2015/080990.

A titre d'exemple de matériau pérovskite, on peut notamment citer les pérovskites hybrides organiques-inorganiques. Ces matériaux pérovskites hybrides peuvent être plus particulièrement de formule ABX3 précitée, dans laquelle A comprend un ou plusieurs cations organiques. Par « cation organique », on entend un cation comprenant au moins un groupe organique.

Un tel cation organique peut être par exemple un cation organo-ammonium de formule générale [NR4]⁺ avec au moins un R représentant un groupe organique, par exemple un groupement C₁-C₅-alkyle, par exemple un cation de type méthylammonium (MA), ou encore un cation formamidium (FA) de formule [R₂NCHNR₂]⁺, avec R pouvant par exemple représenter un atome d'hydrogène ou un groupement C₁-C₅-alkyle.

Le ou lesdits cations organiques du matériau pérovskite hybride peuvent être éventuellement associés à un ou plusieurs cations métalliques, par exemple du césium et/ou du rubidium.

A titre d'exemples de matériaux pérovskites hybrides, on peut plus particulièrement citer les pérovskites de formule ABX3, avec
- A représentant un cation organo-ammonium par exemple de type méthylammonium (MA), un cation formamidium (FA) ou un mélange de ces deux cations, éventuellement associé à du césium et/ou du rubidium ;
- B étant choisi parmi le plomb, l'étain, le bismuth, l'antimoine et leurs mélanges ; et
- X étant choisi parmi le chlore, le brome, l'iode et leurs mélanges.

Le matériau pérovskite hybride peut être par exemple CH₃NH₃PbI₃, le plomb pouvant être remplacé par l'étain ou le germanium et l'iode pouvant être remplacé par le chlore ou le brome.

### COUCHE SEMI-CONDUCTRICE DE TYPE N

Un matériau « de type N » désigne un matériau qui permet le transport des électrons (e⁻).

Un tel matériau peut être formé de nanoparticules d'oxyde(s) métallique(s) de type N.

Ces nanoparticules d'oxydes métalliques de type N peuvent être choisies parmi l'oxyde de zinc ZnO, les oxydes de titane TiOₓ avec x compris entre 1 et 2, l'oxyde d'étain (SnO₂), les oxydes de zinc dopés, par exemple l'oxyde de zinc dopé à l'aluminium (AZO), l'oxyde de zinc dopé à l'indium (IZO), l'oxyde de zinc dopé au gallium (GZO), les oxydes de titane dopés, par exemple l'oxyde de titane dopé à l'azote, au phosphore, au fer, au tungstène ou au manganèse et leurs mélanges.

Un matériau de type N peut être également carboné et notamment choisi parmi le polyéthylènimine éthoxylé (PEIE), le poly[(9,9-bis(3'-(N,N-diméthylamino)propyl)-2,7-fluorène)-alt-2,7-(9,9-dioctylfluorène) (PFN).

Le matériau carboné semi-conducteur de type N peut être également choisi parmi les matériaux contenant des motifs :
- pérylènes
- fullerènes, par exemple le fullerène C60, le fullerène C70, le fullerène C80 ou le fullerène C84.
- les nano-tubes de carbone semi-conducteurs ;
- le graphène et les nanographènes ;
- et leurs dérivés solubles, tels que le [6,6]-phényl-C61-butyrate de méthyle également connu sous le nom PCBM ou PC61BM, le [6,6]-phényl-C71-butyrate de méthyle ou PC71BM, un thiophène-C61-butyrate de méthyle, un multi-adduit d'un fullerène C60 ou C70 ou des nanotubes de carbone fonctionnalisés ;

### PROCEDE DE PREPARATION D'UN EMPILEMENT SELON L'INVENTION

Avantageusement, un empilement selon l'invention peut au moins en partie, voire totalement, être effectué par voie humide.

En particulier, le dépôt d'une solution au cours du procédé de fabrication, en particulier pour former chacune des couches N, P et la couche active de pérovskite, peut être réalisé au moyen d'une technique choisie parmi le dépôt à la tournette ou enduction centrifuge (« spin-coating » en langue anglaise), le dépôt au racloir, le couchage à lame (« blade-coating » en langue anglaise), le dépôt par spray ultrasonique, l'enduction par filière à fente (« slot-die » en langue anglaise), l'impression jet d'encre, l'héliogravure, la flexographie et la sérigraphie.

Notamment, tous les revêtements formés au cours des étapes du procédé peuvent être effectués à l'aide d'une unique technique choisie parmi celles décrites ci-dessus.

La technique de dépôt peut être choisie par l'homme du métier en fonction des propriétés de fluidité et des constituants de la solution à déposer.

Une couche peut être obtenue par au moins une, voire plusieurs étapes de dépôt.

Avantageusement, ces étapes de dépôt peuvent être effectuées par voie humide.

Comme évoqué précédemment, la couche conductrice de PEDOT avec contre-ions, en particulier de PEDOT:PSS, est formée à partir d'une formulation de PEDOT en milieu apolaire.

De fait, compte-tenu de la sensibilité de la pérovskite vis-à-vis des solvants polaires en général, de l'eau et des alcools en particulier, des formulations de PEDOT, par exemple de PEDOT:PSS, incluant de tels solvants polaires ne peuvent être utilisées.

Ainsi, les solvants de type éthers (par exemple les éthers d'alkyles et les éthers de glycol) et esters (acétate, benzoate ou lactones par exemple) sont à privilégier pour la formulation de PEDOT avec contre-ions mise en œuvre pour former la couche conductrice à base de PEDOT d'une structure conductrice de type P selon l'invention.

### DISPOSITIF PHOTOVOLTAIQUE

Un dispositif photovoltaïque selon l'invention comporte un empilement multicouche selon l'invention. Il peut être une cellule photovoltaïque.

L'invention pourra être mieux comprise à la lecture de la description détaillée qui va suivre, donnée en référence aux dessins annexés sur lesquels :

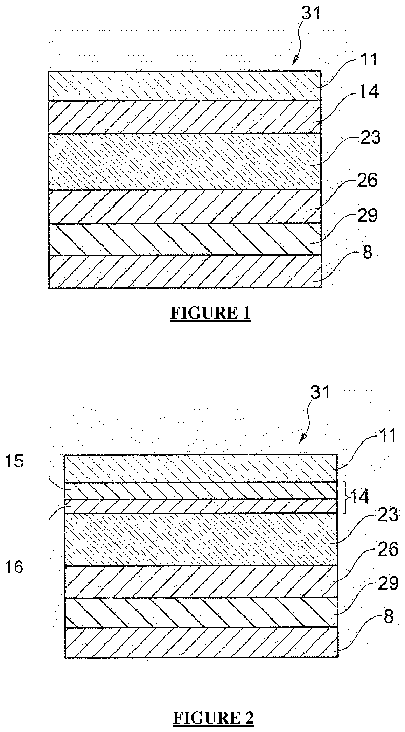

- la figure 1 représente, de manière schématique, dans un plan vertical de coupe, une structure multicouche d'une cellule photovoltaïque (31) classique

Cette cellule comprend de bas en haut les couches suivantes : un substrat 8, une première électrode 29, une couche 26 conductrice de type N (EIL), une couche active Pérovskite 23, une couche 14 conductrice de type P (HTL) et une seconde électrode 11.
- la figure 2 représente, de manière schématique, dans un plan vertical de coupe, une structure multicouche d'une cellule photovoltaïque (31) intégrant une structure conductrice de type P (20) selon l'invention.

Cette cellule comprend de bas en haut les couches suivantes: un substrat 8, une première électrode 29, une couche 26 conductrice de type N (EIL), une couche active Pérovskite 23, une structure 14 conductrice de type P formée d'une couche 16 de type PEDOT:PSS et d'une couche 15 de type P3HT et une seconde électrode 11.

Il convient de noter que, pour des raisons de clarté, les différents éléments sur les figures 1 à 2 sont représentés en échelle libre, les dimensions réelles des différentes couches n'étant pas respectées.

Notamment, comme illustré en figure 2, une cellule photovoltaïque selon l'invention peut comporter une succession de couches superposées et jointives les unes aux autres, dans l'ordre suivant :
- un support (8), telle qu'une plaque, par exemple en verre ou en matière plastique, de préférence en PEN et/ou en PET ;
- une couche transparente conductrice en tant qu'anode (29), par exemple en oxyde d'indium dopé à l'étain (ITO) ;
- un empilement multicouche conforme à l'invention (26), (23) et (14) ; et
- une couche conductrice en tant que cathode (11), par exemple en argent ou en or.

La cellule selon l'invention est de préférence de type NIP, c'est-à-dire que la couche de type N est au contact de l'ensemble support et couche transparente conductrice. La structure conductrice de type P d'un empilement selon l'invention, présente un intérêt particulier pour une structure de type NIP.

La cellule photovoltaïque comporte de préférence des moyens de connexion électrique (non représentés en figures 1 et 2), notamment des reprises de contact, qui permettent de relier les électrodes pour alimenter en courant un circuit électrique.

Selon un mode de réalisation particulier, le substrat 8 est en verre.

La première électrode (29), au contact du support, est par exemple formée d'une couche en un matériau choisi parmi les oxydes conducteurs transparents (TCO) tels que l'oxyde d'étain dopé à l'indium (ITO), l'oxyde de zinc dopé à l'aluminium (AZO), l'oxyde de zinc dopé au gallium (GZO), l'oxyde de zinc dopé à l'indium (IZO) et leurs mélanges, ou formée d'un ensemble multicouche AZO/Ag/AZO.

La deuxième électrode (11) est de préférence formée par une couche en or, en argent, ou par un réseau de nanofils, de préférence en argent. Elle peut également être en aluminium ou en oxyde conducteur transparent.

### EXEMPLE

### 1. Méthodes de mesure

Les performances photovoltaïques des cellules sont mesurées en enregistrant les caractéristiques courant-tension des dispositifs sur un appareil Keithley^{®} SMU 2600 sous éclairement AM 1,5G à une puissance de 1000 W.m⁻².

La cellule testée est éclairée au travers de la face Verre/ITO à l'aide d'un simulateur Oriel.

Une cellule silicium mono-cristallin calibrée au Fraunhofer ISE (Fribourg, Allemagne) est utilisée comme référence pour s'assurer que la puissance lumineuse délivrée par le simulateur est bien égale à 1000 W.m⁻².

Les paramètres caractéristiques du fonctionnement des dispositifs (Tension de circuit ouvert Voc, densité de courant de court-circuit Jsc, facteur de forme FF et rendement de conversion PCE) sont déterminés à partir de ces courbes.

### 2. Formation d'un empilement conforme à l'invention

- Le support est une plaque de verre d'une épaisseur de 1,1 mm, recouverte d'une couche d'ITO de 230 nm formant une électrode.
- Le matériau pérovskite est de type CH₃NH₃PbI₃₋ₓClₓ.
- La couche de type N est un film d'oxyde de zinc dopé à l'aluminium, d'une épaisseur de l'ordre 80 nm.
- La couche de type P est :
   a) soit un film conducteur de PEDOT:PSS de 100 nm d'épaisseur (Témoin) ;
   b) soit un film semi-conducteur de P3HT de 80 nm d'épaisseur (Témoin) ;
   c) soit un empilement selon l'invention formé d'une couche de PEDOT:PSS de 100 nm d'épaisseur liée jointivement à une fine couche de P3HT de 15 nm d'épaisseur, la couche de PEDOT:PSS étant au contact de la couche active en matériau pérovskite ; et
- L'électrode supérieure est une couche d'or d'une épaisseur de 100 nm.

Les trois premières couches (couche N, couche active pérovskite et couche P) ont été mises en œuvre par spin-coating alors que l'électrode d'or a été évaporée.

La surface active des dispositifs est de 0,28 cm² et leurs performances ont été mesurées à 25°C dans des conditions standards d'éclairement (1000 W/m², AM 1,5G).

L'ensemble de ces étapes sont réalisées en boîte à gants sous atmosphère inerte.

Les performances de l'empilement selon l'invention et des deux empilements témoins ont ensuite été testées.

Les données obtenues sont présentées dans le Tableau 1 ci-après.

**TABLEAU 1**

| Couche P | Voc (mV) | Jsc (mA/cm²) | FF (%) | Rendement (%) |
|---|---|---|---|---|
| P3HT (80 nm) | 943,1 +/- 45,7 | 17,3 +/- 2 | 55,2 +/- 4,6 | 8,9 +/- 0,9 |
| PEDOT:PSS | 919,8+/- 14,9 | 11,1+/- 1,7 | 62,6+/- 3,7 | 6,4+/- 0,9 |
| P3HT(15 nm) / PEDOT :PSS | 945,0 +/- 17,9 | 15,5 +/- 1,9 | 63,5 +/- 3,4 | 9,3 +/- 0,9 |

Comme l'indiquent ces données, les performances photovoltaïques obtenues pour l'empilement selon l'invention, combinant une fine couche de P3HT à une couche PEDOT PSS, sont effectivement supérieures à celles obtenues avec une couche P3HT de référence.

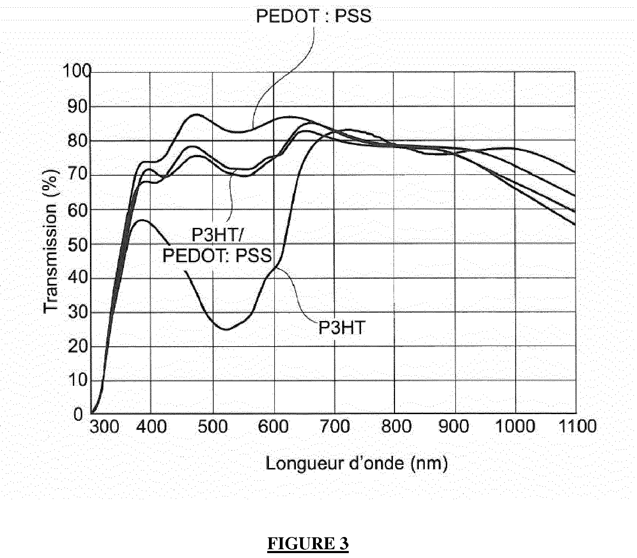

La figure 3 illustre en outre la transmission d'un empilement P3HT (15 nm) / PEDOT:PSS (100 nm). Il y est confirmé le maintien d'une transmission d'au moins 70 % sur la gamme d'absorption d'intérêt (400-1000 nm).

## Revendications

1. Empilement multicouche utile pour former un dispositif photovoltaïque, ledit empilement comportant au moins une succession de couches superposées et jointives les unes aux autres dans l'ordre suivant :
(a) une couche (26) semi-conductrice de type N, dite couche d'injection d'électrons ;
(b) une couche active de type pérovskite (23) ;
(c) une structure (14) conductrice de type P, dite couche de transport de trous, comprenant au moins une couche (16) d'un matériau conducteur à base de poly(3,4-éthylènedioxythiophène) (PEDOT) associé à un ou plusieurs contre-ions choisis parmi le poly(styrène sulfonate) (PSS), le tosylate (OTs), le triflate (OTf) et le méthylsulfonate (OMs) ;
**caractérisé en ce que** la structure de type P comprend en outre au moins une couche (15) de polymère semi-conducteur π-conjugué, distinct du PEDOT et comprenant au moins un motif thiophène, ladite couche étant jointive à l'une des faces de ladite couche de matériau conducteur à base de PEDOT,
ladite couche de matériau conducteur à base de PEDOT avec contre-ion(s) possédant une épaisseur inférieure ou égale à 200 nm, et
ladite couche en polymère semi-conducteur π-conjugué possédant une épaisseur inférieure ou égale à 20 nm.

2. Empilement selon la revendication 1, dans lequel ladite structure conductrice de type P (14) est formée d'une couche (16) de matériau conducteur à base de PEDOT avec contre-ion(s) et d'une couche (15) dudit polymère semi-conducteur π-conjugué disposée à l'interface de ladite couche à base de PEDOT et de la couche active (23).

3. Empilement selon la revendication 1, dans lequel ladite structure conductrice de type P (14) est formée d'une couche (16) de matériau conducteur à base de PEDOT avec contre-ion(s) et d'une couche (15) de polymère semi-conducteur π-conjugué disposée sur la face de ladite couche de matériau conducteur à base de PEDOT non contigüe à la couche active (23).

4. Empilement selon la revendication 1, dans lequel ladite structure conductrice de type P (14) est constituée de la succession de couches superposées et jointives les unes aux autres dans l'ordre suivant : couche (15) dudit polymère semi-conducteur π-conjugué / couche (16) de matériau conducteur à base de PEDOT avec contre-ion(s)/ couche (15) dudit polymère semi-conducteur π-conjugué.

5. Empilement selon l'une quelconque des revendications précédentes, dans lequel ladite couche (16) de matériau conducteur à base de PEDOT avec contre-ion(s) possède une épaisseur inférieure ou égale à 100 nm.

6. Empilement selon l'une quelconque des revendications précédentes, dans lequel ladite structure conductrice de type P (14) comprend une couche de PEDOT :PSS.

7. Empilement selon l'une quelconque des revendications précédentes, dans lequel ladite couche (15) en polymère semi-conducteur π-conjugué possède une épaisseur inférieure ou égale à 15 nm.

8. Empilement selon l'une quelconque des revendications 1 à 3 et 5 à 10, dans lequel ladite couche (15) de polymère semi-conducteur π-conjugué (SC) et ladite couche (16) de matériau conducteur de type PEDOT avec contre-ion(s) (C) sont considérées dans un rapport d'épaisseur (SC)/(C) compris entre 1/100 et 1/5, et de préférence de l'ordre de 1/10, dans une architecture considérant une unique couche de chacun des matériaux.

9. Empilement selon l'une quelconque des revendications 1 et 4 à 10, comprenant à titre de structure conductrice de type P (14) un empilement formé d'une couche (15) dudit polymère semi-conducteur π-conjugué (SC) / couche (16) de matériau conducteur de type PEDOT avec contre-ion(s) (C)/ couche (15) dudit polymère semi-conducteur π-conjugué (SC), ayant un rapport d'épaisseur (SC)/(C)/(SC) compris entre 1/100/1 et 1/5/1, de préférence de l'ordre de 1/10/1.

10. Empilement selon l'une quelconque des revendications précédentes, dans lequel ledit polymère semi-conducteur π-conjugué est choisi parmi les poly(3-hexylthiophène) ou P3HT, poly[N- 9'-heptadecanyl-2,7-carbazole-alt-5,5-(4,7-di-2-thienyl-2',1',3'-benzothiadiazole ou PCDTBT, poly[2,1,3-benzothiadiazole-4,7-diyl[4,4-bis(2-ethylhexyl)-4H-cyclopenta[2,1-b:3,4-b']dithiophene-2,6-diyl]] ou PCPDTBT, le Poly(benzo[1,2-b:4,5-b']dithiophene-alt-thieno[3,4-c]pyrrole-4,6-dione) PBDTTPD, poly[[4,8-bis[(2-ethylhexyl)oxy] benzo [1,2-b:4,5-b']dithiophene-2,6-diyl][3-fluoro-2-[(2-ethylhexyl) carbonyl]thieno[3,4-b]thiophenediyl]] ou PTB7.

11. Empilement selon l'une quelconque des revendications précédentes, dans lequel ledit polymère semi-conducteur π-conjugué est un poly(3-hexylthiophène) ou P3HT.

12. Empilement selon l'une quelconque des revendications 1 à 11, comprenant à titre de structure conductrice de type P (14) au moins une couche de P3HT disposée à l'interface de ladite couche active de type pérovskite (23) et d'une couche PEDOT:PSS et/ou disposée sur la face de ladite couche PEDOT:PSS non contigüe à la couche active (23).

13. Empilement selon l'une quelconque des revendications précédentes, dans lequel ledit matériau de type N est choisi parmi l'oxyde de zinc, les oxydes de titane TiOₓ avec x compris entre 1 et 2, l'oxyde d'étain, les oxydes de zinc dopés, par exemple l'oxyde de zinc dopé à l'aluminium, l'oxyde de zinc dopé à l'indium et l'oxyde de zinc dopé au gallium ; les oxydes de titane dopés, par exemple l'oxyde de titane dopé à l'azote, au phosphore, au fer, au tungstène ou au manganèse, et leurs mélanges.

14. Dispositif photovoltaïque, en particulier cellule photovoltaïque (31) de type pérovskite, notamment de type tandem, comportant au moins un empilement tel que défini selon l'une quelconque des revendications précédentes.

15. Dispositif selon la revendication 14 comportant une succession de couches superposées et jointives les unes aux autres, dans l'ordre suivant :
- un support (8), telle qu'une plaque, par exemple en verre ou en matière plastique, de préférence en PEN et/ou en PET,
- une couche transparente conductrice en tant qu'anode (29), par exemple en oxyde d'indium dopé à l'étain (ITO) ;
- un empilement multicouche selon l'une quelconque des revendications 1 à 13 ; et
- une couche conductrice en tant que cathode (11), par exemple en argent ou en or.

## Patentansprüche

1. Mehrschichtige Aufschichtung, mittels derer eine photovoltaische Vorrichtung gebildet werden kann, wobei die Aufschichtung zumindest eine Abfolge von Schichten aufweist, die übereinander angeordnet sind und in der folgenden Reihenfolge aneinandergefügt sind:
(a) eine Halbleiterschicht (26) des Typs N, die als elektroneneinleitende Schicht bezeichnet wird;
(b) eine aktive Schicht des Typs Perowskit (23);
(c) eine leitfähige Struktur (14) des Typs P, welche als Löchertransportschicht bezeichnet wird, wobei sie mindestens eine Schicht (16) aus einem leitfähigen Material auf Basis von Poly(3,4-ethylendioxythiophen) (PEDOT) in Verbindung mit einem oder mehreren Gegenionen umfasst, welche aus Poly(styrolsulfonat) (PSS), Tosylat (OTs), Triflat (OTf) und Methylsulfonat (OMs) ausgewählt sind;
**dadurch gekennzeichnet, dass** die Struktur des Typs P darüber hinaus mindestens eine Schicht (15) aus einem π-konjugierten halbleitenden Polymer umfasst, welches sich von PEDOT unterscheidet und mindestens einen Thiophenbaustein umfasst, wobei die Schicht an eine der Seiten der Schicht aus einem leitfähigen Material auf Basis von PEDOT angefügt ist,
wobei die Schicht aus einem leitfähigen Material auf Basis von PEDOT mit (einem) Gegenion(en) eine Dicke von höchstens 200 nm besitzt, und
wobei die Schicht aus π-konjugiertem halbleitenden Polymer eine Dicke von höchstens 20 nm besitzt.

2. Aufschichtung nach Anspruch 1, wobei die leitfähige Struktur des Typs P (14) ausgehend von einer Schicht (16) aus leitfähigem Material auf Basis von PEDOT mit (einem) Gegenion(en) und von einer Schicht (15) des π-konjugierten halbleitenden Polymers gebildet ist, welche an der Grenzfläche der Schicht auf Basis von PEDOT und der aktiven Schicht (23) angeordnet ist.

3. Aufschichtung nach Anspruch 1, wobei die leitfähige Struktur des Typs P (14) ausgehend von einer Schicht (16) aus leitfähigem Material auf Basis von PEDOT mit (einem) Gegenion(en) und von einer Schicht (15) aus π-konjugiertem halbleitenden Polymer gebildet ist, die auf derjenigen Seite der Schicht aus leitfähigem Material auf Basis von PEDOT angeordnet ist, welche nicht an die aktive Schicht (23) anschließt.

4. Aufschichtung nach Anspruch 1, wobei die leitfähige Struktur des Typs P (14) aus der Abfolge von Schichten besteht, welche übereinander angeordnet in der folgenden Reihenfolge aneinandergefügt sind: Schicht (15) aus dem π-konjugierten halbleitenden Polymer / Schicht (16) aus leitfähigem Material auf Basis von PEDOT mit (einem) Gegenion(en) / Schicht (15) aus dem π-konjugierten halbleitenden Polymer.

5. Aufschichtung nach einem beliebigen der vorhergehenden Ansprüche, wobei die Schicht (16) aus leitfähigem Material auf Basis von PEDOT mit (einem) Gegenion(en) eine Dicke von höchstens 100 nm besitzt.

6. Aufschichtung nach einem beliebigen der vorhergehenden Ansprüche, wobei die leitfähige Struktur des Typs P (14) eine Schicht aus PEDOT:PSS umfasst.

7. Aufschichtung nach einem beliebigen der vorhergehenden Ansprüche, wobei die Schicht (15) aus π-konjugiertem halbleitenden Polymer eine Dicke von höchstens 15 nm besitzt.

8. Aufschichtung nach einem beliebigen der Ansprüche 1 bis 3 und 5 bis 10, wobei die Schicht (15) aus π-konjugiertem halbleitenden Polymer (SC) und die Schicht (16) aus leitfähigem Material auf Basis von PEDOT mit (einem) Gegenion(en) (C) in einem Aufbau, in welchem von jedem dieser Materialien nur eine einzige Schicht vorgesehen ist, derart vorliegen, dass das Dickenverhältnis (SC)/(C) im Bereich von 1/100 bis 1/5 liegt, wobei es vorzugsweise in der Größenordnung von 1/10 liegt.

9. Aufschichtung nach einem beliebigen der Ansprüche 1 und 4 bis 10, die als leitfähige Struktur des Typs P (14) eine Aufschichtung umfasst, welche aus einer Schicht (15) aus dem π-konjugierten halbleitenden Polymer (SC) / Schicht (16) aus leitfähigem Material auf Basis von PEDOT mit (einem) Gegenion(en) (C) / Schicht (15) aus dem π-konjugierten halbleitenden Polymer (SC) gebildet ist, wobei das Dickenverhältnis (SC)/(C)/(SC) im Bereich von 1/100/1 bis 1/5/1 liegt, wobei es vorzugsweise in der Größenordnung von 1/10/1 liegt.

10. Aufschichtung nach einem beliebigen der vorhergehenden Ansprüche, wobei das π-konjugierte halbleitende Polymer aus Poly(3-hexylthiophen) oder P3HT, Poly[N-9'-heptadecanyl-2,7-carbazol-alt-5,5-(4,7-di-2-thienyl-2',1',3'-benzothiadiazol oder PCDTBT, Poly[2,1,3-benzothiadiazol-4,7-diyl[4,4-bis(2-ethylhexyl)-4H-cyclopenta[2,1-b:3,4-b']dithiophen-2,6-diyl]] oder PCPDTBT, Poly(benzo[1,2-b:4,5-b']dithiophen-alt-thieno[3,4-c]pyrrol-4,6-dion) PBDTTPD, Poly[[4,8-bis[(2-ethylhexyl)oxy]benzo[1,2-b:4,5-b']dithiophen-2,6-diyl][3-fluor-2-[(2-ethylhexyl)carbonyl]thieno[3,4-b]thiophenediyl]] oder PTB7 ausgewählt ist.

11. Aufschichtung nach einem beliebigen der vorhergehenden Ansprüche, wobei es sich bei dem π-konjugierten halbleitenden Polymer um ein Poly(3-hexylthiophen) oder P3HT handelt.

12. Aufschichtung nach einem beliebigen der Ansprüche 1 bis 11, wobei sie als leitfähige Struktur des Typs P (14) mindestens eine P3HT-Schicht umfasst, welche an der Grenzfläche der aktiven Schicht des Typs Perowskit (23) und einer PEDOT:PSS-Schicht angeordnet ist und/oder auf derjenigen Seite der PEDOT:PSS-Schicht angeordnet ist, welche nicht an die aktive Schicht (23) anschließt.

13. Aufschichtung nach einem beliebigen der vorhergehenden Ansprüche, wobei das Material des Typs N aus Zinkoxid, den Titanoxiden TiOₓ, mit x im Bereich von 1 bis 2, Zinnoxid, den dotierten Zinkoxiden, beispielsweise mit Aluminium dotiertem Zinkoxid, mit Indium dotiertem Zinkoxid und mit Gallium dotiertem Zinkoxid; den dotierten Titanoxiden, beispielsweise mit Stickstoff, mit Phosphor, mit Eisen, mit Wolfram oder mit Mangan dotiertem Titanoxid, und deren Mischungen ausgewählt ist.

14. Photovoltaische Vorrichtung, insbesondere photovoltaische Zelle (31) des Typs Perowskit, insbesondere vom Tandem-Typ, wobei sie mindestens eine Aufschichtung gemäß der Begriffsbestimmung in einem beliebigen der vorhergehenden Ansprüche aufweist.

15. Vorrichtung nach Anspruch 14, wobei sie eine Abfolge von Schichten aufweist, die übereinander angeordnet und in der folgenden Reihenfolge aneinandergefügt sind:
- einen Träger (8), wie etwa eine Platte, beispielsweise aus Glas oder Kunststoff, vorzugsweise aus PEN und/oder aus PET,
- eine leitfähige durchsichtige Schicht als Anode (29), beispielsweise aus Indiumoxid, welches mit Zinn dotiert ist (ITO);
- eine mehrschichtige Aufschichtung nach einem beliebigen der Ansprüche 1 bis 13; und
- eine leitfähige Schicht als Kathode (11), beispielsweise aus Silber oder aus Gold.

## Claims

1. Multilayer stack of use in forming a photovoltaic device, said stack comprising at least one succession of superposed layers that are contiguous with one another in the following order:
(a) an n-type semiconducting layer (26), referred to as electron injection layer;
(b) a perovskite-type active layer (23);
(c) a p-type conducting structure (14), referred to as hole transport layer, comprising at least one layer (16) of a conducting material based on poly(3,4-ethylenedioxythiophene) (PEDOT) combined with one or more counterions chosen from poly(styrene sulfonate) (PSS), tosylate (OTs), triflate (OTf) and methylsulfonate (OMs);
**characterized in that** the p-type structure further comprises at least one layer (15) of π-conjugated semiconducting polymer, different from PEDOT and comprising at least one thiophene unit, said layer being contiguous with one of the faces of said layer of PEDOT-based conducting material,
said layer of conducting material based on PEDOT with counterion(s) having a thickness less than or equal to 200 nm, and
said layer of π-conjugated semiconducting polymer having a thickness less than or equal to 20 nm.

2. Stack according to Claim 1, in which said p-type conducting structure (14) is formed from a layer (16) of conducting material based on PEDOT with counterion(s) and from a layer (15) of said π-conjugated semiconducting polymer positioned at the interface of said PEDOT-based layer and the active layer (23).

3. Stack according to Claim 1, in which said p-type conducting structure (14) is formed from a layer (16) of conducting material based on PEDOT with counterion(s) and from a layer (15) of π-conjugated semiconducting polymer positioned on the face of said layer of PEDOT-based conducting material that is not contiguous with the active layer (23).

4. Stack according to Claim 1, in which said p-type conducting structure (14) is constituted of the succession of superposed layers that are contiguous with one another in the following order: layer (15) of said π-conjugated semiconducting polymer / layer (16) of conducting material based on PEDOT with counterion(s) / layer (15) of said π-conjugated semiconducting polymer.

5. Stack according to any one of the preceding claims, in which said layer (16) of conducting material based on PEDOT with counterion(s) has a thickness less than or equal to 100 nm.

6. Stack according to any one of the preceding claims, in which said p-type conducting structure (14) comprises a layer of PEDOT:PSS.

7. Stack according to any one of the preceding claims, in which said layer (15) of π-conjugated semiconducting polymer has a thickness less than or equal to 15 nm.

8. Stack according to any one of Claims 1 to 3 and 5 to 10, in which said layer (15) of π-conjugated semiconducting polymer (SC) and said layer (16) of conducting material of PEDOT type with counterion(s) (C) are considered in an (SC)/(C) thickness ratio of between 1/100 and 1/5, and preferably of the order of 1/10, in an architecture considering a single layer of each of the materials.

9. Stack according to any one of Claims 1 and 4 to 10, comprising, as p-type conducting structure (14), a stack formed of a layer (15) of said π-conjugated semiconducting polymer (SC) / layer (16) of conducting material of PEDOT type with counterion(s) (C) / layer (15) of said π-conjugated semiconducting polymer (SC), having an (SC)/(C)/(SC) thickness ratio of between 1/100/1 and 1/5/1, preferably of the order of 1/10/1.

10. Stack according to any one of the preceding claims, in which said π-conjugated semiconducting polymer is chosen from poly(3-hexylthiophene) or P3HT, poly[N-9'-heptadecanyl-2,7-carbazole-alt-5,5-(4,7-di-2-thienyl-2',1',3'-benzothiadiazole or PCDTBT, poly[2,1,3-benzothiadiazole-4,7-diyl[4,4-bis(2-ethylhexyl)-4H-cyclopenta[2,1-b:3,4-b']dithiophene-2,6-diyl]] or PCPDTBT, poly(benzo[1,2-b:4,5-b']dithiophene-alt-thieno[3,4-c]pyrrole-4,6-dione) PBDTTPD, poly[[4,8-bis[(2-ethylhexyl)oxy]benzo[1,2-b:4,5-b']dithiophene-2,6-diyl][3-fluoro-2-[(2-ethylhexyl)carbonyl]thieno-[3,4-b]thiophenediyl]] or PTB7.

11. Stack according to any one of the preceding claims, in which said π-conjugated semiconducting polymer is a poly(3-hexylthiophene) or P3HT.

12. Stack according to any one of Claims 1 to 11, comprising, as p-type conducting structure (14), at least one layer of P3HT positioned at the interface of said perovskite-type active layer (23) and of a PEDOT:PSS layer and/or positioned on the face of said PEDOT:PSS layer that is not contiguous with the active layer (23).

13. Stack according to any one of the preceding claims, in which said n-type material is chosen from zinc oxide, titanium oxides TiOₓ with x between 1 and 2, tin oxide, doped zinc oxides, for example aluminium-doped zinc oxide, indium-doped zinc oxide and gallium-doped zinc oxide, doped titanium oxides, for example titanium oxide doped with nitrogen, phosphorus, iron, tungsten or manganese, and mixtures thereof.

14. Photovoltaic device, in particular photovoltaic cell (31) of perovskite type, notably of tandem type, comprising at least one stack as defined according to any one of the preceding claims.

15. Device according to Claim 14, comprising a succession of superposed layers that are contiguous with one another, in the following order:
- a support (8), such as a plate, for example made of glass or plastic, preferably made of PEN and/or PET,
- a transparent conducting layer as anode (29), for example made of tin-doped indium oxide (ITO);
- a multilayer stack according to any one of Claims 1 to 13; and
- a conducting layer as cathode (11), for example made of silver or gold.
